(19) Europäisches Patentamt
European Patent Office
Office européen des brevets

(11) **EP 4 546 040 A1**

(12) **EUROPEAN PATENT APPLICATION**
published in accordance with Art. 153(4) EPC

(43) Date of publication:
30.04.2025 Bulletin 2025/18

(21) Application number: 23826577.1

(22) Date of filing: 24.06.2023

(51) International Patent Classification (IPC):
*G02F 1/13357* (2006.01)    *H01L 33/00* (2010.01)
*H01L 25/075* (2006.01)    *H01L 33/48* (2010.01)
*H01L 33/62* (2010.01)

(52) Cooperative Patent Classification (CPC):
G02F 1/1336; H01L 25/075; H10H 20/80;
H10H 20/85; H10H 20/857

(86) International application number:
PCT/CN2023/102012

(87) International publication number:
WO 2023/246932 (28.12.2023 Gazette 2023/52)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 24.06.2022  CN 202210728844
15.07.2022  CN 202210836291
30.08.2022  CN 202211060483
13.12.2022  CN 202211601093

(71) Applicant: Huizhou Jufei Optoelectronics Ltd.
Huizhou, Guangdong 516000 (CN)

(72) Inventors:
• MA, Wenbo
Huizhou, Guangdong 516000 (CN)
• CHEN, Jianchang
Huizhou, Guangdong 516000 (CN)
• SUN, Pingru
Huizhou, Guangdong 516000 (CN)
• WEI, Donghan
Huizhou, Guangdong 516000 (CN)
• XING, Meizheng
Huizhou, Guangdong 516000 (CN)

(74) Representative: Viering, Jentschura & Partner
mbB
Patent- und Rechtsanwälte
Am Brauhaus 8
01099 Dresden (DE)

(54) **LED LAMP PANEL**

(57)    The present disclosure is applicable for the technical field of LEDs and provides an LED lamp panel which comprises a substrate that is provided with a circuit layer. The circuit layer is provided with bonding pads for connecting with a plurality of LED chips. The circuit layer is provided with a first reflective layer. The first reflective layer is provided with a plurality of window structures, which are disposed in an array. At least one pair of bonding pads for connecting with the LED chips is distributed in each of the window structures. The LED lamp panel further comprises a second reflective layer filled between the first reflective layer and the LED chips. The reflectivity of the second reflective layer is greater than that of the first reflective layer. The LED lamp panel provided by the present disclosure is conducive to die bonding and has a high lighting effect, an improved process yield, and a low manufacturing cost.

FIG. 7

## Description

## TECHNICAL FIELD

The present disclosure is related to the technical field of LED encapsulation, in particular to an LED lamp panel.

## BACKGROUND

In recent years, an LED backlight board can realize local dimming, and the display quality has been greatly improved, which has been favored and vigorously promoted by the market. Mini LED backlight display modules and direct view products have become the mainstream solutions in future display market. In the prior art, on the one hand, since it is necessary to coat a layer of white ink on the glass substrate for a LED backlight board based on the glass substrate, and window-forming treatment is carried out at the position where the LED chip is placed to expose the bonding pad, which is convenient for welding the LED chip with the bonding pad (i.e. die bonding), the window-forming treatment of white ink will greatly affect the lighting effect of the backlight board. If the window is too large (the glass substrate will be exposed), the light emitted by the LED will be lost through the glass, while if the window is too small, the ink will cover the bonding pad and cause a bad die bonding. At the same time, the reflectivity of white ink is generally not high, and the lighting effect of the LED backlight board has been limited by the reflectivity of white ink, which leads to relatively low lighting effect of the LED backlight board, which is not conducive to improving backlight brightness.

On the other hand, in the prior art, the lamp panel of a Mini LED backlight display module adopts a flip-chip technology structure, which is applicable for the demand of an ultrasmall space and is also applicable for encapsulated substrates with various materials. The substrate material for encapsulating the Mini LED backlight display module is generally a printed circuit board (PCB) or a glass substrate. Silicone resin or epoxy resin is generally selected as the encapsulant layer on the surface of the Mini LED backlight display module. The thermal expansion coefficient of the PCB substrate or glass substrate is $(1\text{-}15) \times 10^{-6}/°C$, while the thermal expansion coefficient of silicone resin or epoxy resin is about $(50\text{-}220) \times 10^{-6}/°C$. There is a large thermal expansion mismatch between the substrate and the encapsulant layer, which will make the substrate warp, with the risks of delamination, deformation, poor air tightness, chip peeling, and the like. The substrate and the encapsulant are separated due to inconsistent deformation caused by cold or heat (for example, during cold and hot impact experiments) due to a large difference in thermal expansion coefficient (the thermal expansion coefficient of the encapsulant is much larger than that of the substrate). In the prior art, the deformation is reduced by reducing the difference in thermal expansion coefficient between the substrate and the adjacent encapsulant, but the stress existing in the substrate is not eliminated, and the substrate is easily deformed. It is difficult to reduce the difference of thermal expansion coefficient between the substrate and the adjacent encapsulant, and the production cost is high.

In addition, there are many forms of LED products, and the applications of similar products in end-uses are very different, and therefore customers have various requirements for lamp beads, such as high contrast for display products, high brightness for white light products, color purity for monochromatic light, and the like. However, there are only two kinds of BT (Bismaleimide Triazine) substrates commonly used in LED encapsulation. At the same time, the internal circuit design of PCB needs to meet the process requirements in the encapsulation process, and metal functional areas need to be reserved for solid welding in the LED encapsulation process. Both the metal functional area and the primary color of BT substrate will affect the background color of LED chips after encapsulation. For example, in order to improve the contrast of display products, the black glue encapsulation will greatly reduce the brightness of the products, and at the same time, the bottom functional area cannot be completely covered. The brightness of some white light products requires high brightness, but the size of lamp beads limits the choice of larger chips, in which case the brightness improvement can only be achieved by chip suppliers to improve the luminous efficiency of LED chips, with very little and limited improvement and very high cost. In addition, the conventional encapsulation technology of MINI COB (chip on board) backlight board is that the LED flip chip is die-bonded on the circuit layer of the substrate, and then a layer of transparent protective glue is covered on the LED chip and the circuit layer to realize protection. Since the LED chip generally emits Lambert light, that is, the central part of the LED chip emits light strongly, and the two sides emit light weakly. In order to obtain a larger light emitting angle and a more uniform light emitting, in the prior art, a reflective layer is generally covered directly above the LED chip, so that the light emitted from the front of the LED chip can be reflected to the two sides. However, although a larger light emitting angle can be obtained in this way, since the reflective layer is opaque, the light emitted by the LED chip is repeatedly reflected between the reflective layer and the substrate, and the reflectivity of the substrate is less than 100%. Therefore, in the process of multiple reflections, the substrate will absorb part of the light, and the light loss is large, which obviously reduces the lighting effect and brightness of the backlight board.

In view of the above technical problems existing in the above LED lamp panel and the manufacturing thereof, it is urgent for R&D personnel to make improvements.

## SUMMARY

An object of the present disclosure is to overcome at least one of the shortcomings of the prior art by providing an LED lamp panel, which is conducive to die bonding, which improves the lighting effect and the process yield, and has a low manufacturing cost.

The technical solution of the present disclosure is that an LED lamp panel includes a substrate and an LED chip, a circuit composite layer is disposed on the substrate, and the circuit composite layer is provided with bonding pads for connecting with the LED chip.

As a further improvement of the technical solution, a first reflective layer is disposed on the circuit composite layer, the first reflective layer is provided with a plurality of window structures, each window structure has at least one pair of the bonding pads in a corresponding area, the LED chip is disposed in the window structure and connected to the bonding pads in the corresponding window structure, an accommodating area is formed between the outer periphery of the LED chip and the inner periphery of the window structure, and the LED lamp panel further includes a second reflective layer filled in the accommodating area.

As a further improvement of the technical solution, the circuit composite layer includes a circuit layer and a solder resist layer that is disposed on the circuit layer and has window structures, each of the window structures has at least one pair of the bonding pads in the corresponding area, the LED chip is disposed in the window structure and connected to the bonding pads in the corresponding window structure, the LED lamp panel further includes a first encapsulant layer that is disposed on one side of the substrate, covers the LED chip and the circuit composite layer, and allows the light emitted by the LED chip to pass through, and the LED lamp panel further includes a second encapsulant layer disposed on the other side of the substrate for partially or completely offsetting the stress generated by the first encapsulant layer on the substrate.

As a further improvement of the technical solution, the circuit composite layer includes a circuit layer and a solder resist layer that is disposed on the circuit layer and has window structures, each of the window structure having at least one pair of the bonding pads in the corresponding are, the LED chip is disposed in the window structure and connected to the bonding pads in the corresponding window structure, the LED chip is located in the window structure and connected to the circuit layer, the LED lamp panel further includes a colored glue layer, which is filled in the window structure and is respectively connected with the LED chip and the solder resist layer, and the colored glue layer has a color identical with that of the solder resist layer.

As a further improvement of the technical solution, the second reflective layer is made of resin, and reflective particles are dispersed in the second reflective layer.

As a further improvement of the technical solution, the second reflective layer is formed by glue dispensing in the window structure.

As a further improvement of the technical solution, the LED chip is a flip chip, a gap exists between a side of the LED chip facing the substrate and the substrate, and the second reflective layer includes a side reflective part connected with the outer periphery of the LED chip and a bottom reflective part filled in the gap.

As a further improvement of the technical solution, the surface of the bonding pad is provided with a solder paste layer used for connecting with the LED chip, and the second reflective layer covers the periphery of the joint between the LED chip and the solder paste layer.

As a further improvement of the technical solution, the top surface of the first reflective layer is between the bottom surface and the top surface of the LED chip, and the top surface of the second reflective layer is not higher than the top surface of the first reflective layer.

As a further improvement of the technical solution, the second reflective layer has a reflectivity greater than that of the first reflective layer.

As a further improvement of the technical solution, the first reflective layer is made of white ink.

As a further improvement of the technical solution, the value of the thickness of the first reflective layer ranges from 20 $\mu$m to 80 $\mu$m.

As a further improvement of the technical solution, the dimensions of the window structure satisfy the following relationship:

$$Bx < Px, \ By < Py,$$

where Bx represents the largest dimension of the window structure in the transverse direction, By represents the largest dimension of the window structure in the longitudinal direction, Px represents the transverse spacing between two adjacent LED chips, and Py represents the longitudinal spacing between two adjacent LED chips.

As a further improvement of the technical solution, the window structure is a rectangular through hole, and the length dimension of the rectangular through hole is greater than or equal to $\geq$2mm.

As a further improvement of the technical solution, a plurality of LED chips are provided, the LED lamp panel further includes a plurality of reflection patterns, the second reflective layer covers the substrate and the LED chips, the reflection patterns are disposed on the upper surface of the second reflective layer, the reflection pattern includes a plurality of reflection units disposed at intervals, air gaps are formed between the reflection units, the reflection units include resin and reflection particles dispersed in the resin, the density of the reflection particles in the central area of the reflection pattern is greater than that in the peripheral region of the reflection pattern, the first reflective layer is disposed on a side of the circuit composite layer connected with the LED chip, and a side of the second reflective layer covers the first reflective layer and the LED chips.

As a further improvement of the technical solution, in one of the reflection patterns, the area of the air gap accounts for 20% to 80% of the area of the outline of the reflection pattern,
and/or the reflection pattern has a thickness of 10 μm to 60 μm.

As a further improvement of the technical solution, the reflection units include a reflection ring located in the central area of the reflection pattern.

As a further improvement of the technical solution, the reflection units include a plurality of reflection rings disposed concentrically, and there is a gap between adjacent reflection rings.

As a further improvement of the technical solution, the periphery of the reflection ring is provided with reflection points, and the distribution density of the reflection points decreases with the distance from the center of the reflection pattern.

As a further improvement of the technical solution, the reflection units include a plurality of reflection points around the center of the reflection pattern, and the areas of the reflection points decrease with the distance from the center of the reflection pattern.

As a further improvement of the technical solution, the reflectivity of the reflection units in the central area of the reflection pattern is greater than that of the reflection units in the peripheral area of the reflection pattern.

As a further improvement of the technical solution, the reflection units in the central area of the reflection pattern contain titanium dioxide particles, and the reflection units in the peripheral area of the reflection pattern contain silicon dioxide particles.

As a further improvement of the technical solution, the reflection pattern is formed by screen printing, and the sidewalls of the reflection units are provided with demoulding inclined planes.

As a further improvement of the technical solution, the present disclosure further includes an optical film disposed above the second reflective layer, wherein diffusion patterns are printed on the surface of the optical film, and the diffusion patterns of the optical film and the reflection patterns are disposed in a staggered manner.

As a further improvement of the technical solution, the thickness of the first encapsulant layer is greater than that of the second encapsulant layer, the first encapsulant layer has a first thermal expansion coefficient, and the second encapsulant layer has a second thermal expansion coefficient greater than the first thermal expansion coefficient.

As a further improvement of the technical solution, the first encapsulant layer and the second encapsulant layer are made of the same material, which is epoxy resin or silicone resin.

As a further improvement of the technical solution, the first encapsulant layer is provided with inorganic light-transmitting particles for adjusting the thermal expansion coefficient thereof.

As a further improvement of the technical solution, the inorganic light-transmitting particles settle in the first encapsulant layer, so that the content of the inorganic light-transmitting particles gradually decreases along the direction away from the substrate.

As a further improvement of the technical solution, the particle size of the inorganic light-transmitting particles ranges from 50 nm to 5 μm.

As a further improvement of the technical solution, the inorganic light-transmitting particles are at least one of silica powder or alumina powder.

As a further improvement of the technical solution, the thickness of the first encapsulant layer ranges from 150 μm to 400 μm, and/or the thickness of the second encapsulant layer ranges from 20 μm to 200 μm.

As a further improvement of the technical solution, the first encapsulant layer is in direct contact with the substrate through the window structure.

As a further improvement of the technical solution, an upper end of the colored glue layer and an upper end of the solder resist layer are both lower than an upper end of the LED chip.

As a further improvement of the technical solution, the thickness of the solder resist layer ranges from 20 μm to 50 μm.

As a further improvement of the technical solution, the LED lamp panel further includes encapsulant layers disposed on the top of the solder resist layer and the top of the colored glue layer and covering the LED chips.

As a further improvement of the technical solution, the colored glue layer and the encapsulant layers are made of a same material, which is epoxy resin or silica gel.

As a further improvement of the technical solution, the colors of the colored glue layer and the solder resist layer are white or black.

As a further improvement of the technical solution, the colored glue layer is made of colored ink or colored colloid with a viscosity less than 2000 mPa·s.

As a further improvement of the technical solution, the inner sidewall of the window structure or the circuit layer has a fillet or chamfer structure.

As a further improvement of the technical solution, there are a plurality of window structures, and one or more LED chips are wire-bonded chips or flip chips and are fixed in respective window structures.

The LED lamp panel provided by the present disclosure includes a substrate, wherein the substrate is provided with a circuit layer, the circuit layer is provided with bonding pads for connecting with a plurality of LED chips; the circuit layer is provided with a first reflective layer, the first reflective layer is provided with a plurality of window structures arranged in an array, at least one pair of bonding pads for connecting with the LED chips is distributed in each window structure, the LED lamp panel further includes a second reflective layer filled between the first reflective layer and the LED chips, and the reflectivity of the second reflective layer is greater than that of the first reflective layer; the LED lamp panel provided by the present disclosure is conducive to die bonding, improves the lighting effect, improves the process yield and has low manufacturing cost; alternatively, by disposing the first encapsulant layer on one side of the substrate to cover the LED chip and the circuit layer, the first encapsulant layer allows the light emitted by the LED chip to pass through, and the second encapsulant layer is disposed on the other side of the substrate, so as to partially or completely offset the stress generated by the first encapsulant layer on the substrate, effectively reduce the warpage and deformation of the substrate caused by stress, effectively improve the delamination, deformation, poor air tightness and the like of the lamp panel after encapsulation, and avoid harmful risks such as peeling of LED chips, with a low production cost; alternatively, except that the LED chip is exposed out of the substrate, the colored glue layer with the same color as the solder resist layer is respectively connected with the LED chip and the solder resist layer, and the colored glue layer can completely cover the rest area of the substrate; that is, the colored glue layer is filled in the window structure and can also cover the surrounding area of the LED chip, so that the color consistency of the encapsulated substrate surface can be effectively improved, and different colored glues can be applied to improve the luminous brightness or contrast according to different occasions. For example, when the LED encapsulation structure is used for white LED products, the white glue layer can enhance the reflective effect of the area around the LED chip and effectively improve the white brightness; when the LED encapsulation structure is used in RGB-LED direct view products, the black glue layer can reduce the reflection of the area around the RGB-LED chip, reduce the reflection effect, and effectively improve the contrast; when it is used for monochromatic LED products, the use of a colored glue layer of a corresponding color system can prevent the light emitted by LED chips from mixing with other miscellaneous colors and ensure the purity of light.

## BRIEF DESCRIPTION OF DRAWINGS

In order to explain the technical solution in the embodiment of the present disclosure more clearly, the drawings to be used in the embodiment will be briefly introduced below. Obviously, the drawings in the following description are only some embodiments of the present disclosure, and other drawings can be obtained according to these drawings without creative work for those skilled in the art. In the present disclosure:

FIG. 1 is a schematic structural diagram of a substrate in an LED lamp panel provided in Embodiment 1 of the present disclosure;

FIG. 2 is a schematic structural diagram of a printed circuit layer on a substrate in an LED lamp panel provided in Embodiment 1 of the present disclosure;

FIG. 3 is a schematic structural diagram of an LED lamp panel provided in Embodiment 1 of the present disclosure, in which a first reflective layer is coated on a circuit layer;

FIG. 4 is a structural schematic diagram of an LED lamp panel provided in Embodiment 1 of the present disclosure, in which a first reflective layer is provided with a window structure;

FIG. 5 is a schematic structural diagram of an LED chip welded to a pad in an LED lamp panel provided in Embodiment 1 of the present disclosure;

FIG. 6 is a schematic structural diagram of an LED lamp panel provided by Embodiment 1 of the present disclosure, in which a second reflective material is filled in an accommodating area;

FIG. 7 is a schematic structural diagram of an LED lamp panel provided in Embodiment 1 of the present disclosure;

FIG. 8 is a top view of an LED lamp panel provided in Embodiment 1 of the present disclosure;

FIG. 9 is another top view of an LED lamp panel provided in Embodiment 1 of the present disclosure;

FIG. 10 is a schematic sectional view of an LED lamp panel provided in Embodiment 2 of the present disclosure;

FIG. 11 is a schematic plan view of an LED lamp panel (the reflection area near the center of the LED chip is dense) provided in Embodiment 2 of the present disclosure;

FIG. 12 is a schematic plan view of an LED lamp panel (the reflection pattern is provided with demoulding inclined planes) provided in Embodiment 2 of the present disclosure;

FIG. 13 is a schematic plan view of an LED lamp panel (the central reflection area is circular) provided in Embodiment 2 of the present disclosure;

FIG. 14 is a schematic plan view of an LED lamp panel (the size of the reflection area near the center of the LED chip is large) provided by Embodiment 2 of the present disclosure;

FIG. 15 is a schematic sectional view of an LED lamp panel provided in Embodiment 2 of the present disclosure with an optical film;

FIG. 16 is a schematic plan view of an LED lamp panel provided by Embodiment 2 of the present disclosure with an optical film;

FIG. 17 is a schematic structural diagram of an LED lamp panel provided in Embodiment 3 of the present disclosure, in which a first encapsulant layer is disposed on one side of a substrate;

FIG. 18 is a schematic structural diagram of an LED lamp panel provided in Embodiment 3 of the present disclosure, in which a second encapsulant layer is disposed on the other side of the substrate;

FIG. 19 is a schematic diagram of an LED lamp panel provided in Embodiment 3 of the present disclosure, in which inorganic light-transmitting particles settle in a first encapsulant layer;

FIG. 20 is a schematic structural diagram of an LED lamp panel provided in Embodiment 4 of the present disclosure;

FIG. 21 is a schematic structural view of an LED lamp panel provided in another Embodiment of Embodiment 4 of the present disclosure;

FIG. 22 is another structural schematic diagram of an LED lamp panel provided in Embodiment 4 of the present disclosure;

FIG. 23 is a schematic structural view of an LED lamp panel provided in another embodiment of Embodiment 4 of the present disclosure; and

FIG. 24 is a partial enlarged view at A in FIG. 23.

## DESCRIPTION OF EMBODIMENTS

In order to make the purpose, technical solution and advantages of the present disclosure more clear, the present disclosure will be further described in detail with the attached drawings and examples. It should be appreciated that the specific embodiments described here are only for explaining the present disclosure and are not intended to limit the present disclosure.

It should be noted that the terms "dispose" and "connect" should be broadly understood; for example, they can be directly disposed and connected or indirectly disposed and connected through an intermediate component or an intermediate structure.

In addition, if there are expressions indicating the orientation or position relationship such as "vertical," "horizontal," "length," "width," "thickness," "top," "bottom," "front," "back," "left," "right," "vertical," "horizontal," "top," and "bottom" in the embodiment of the present disclosure, they are based on the orientational or positional relationship shown in the drawings or the conventional placing state or use state, rather than indicating or implying that the referred structure, feature, device, or element must have a specific orientational or positional relationship, nor must it be constructed and operated in a specific orientation; therefore they cannot be construed as limiting the present disclosure. In the description of the present disclosure, unless otherwise specified, "plural" means two or more.

Each specific technical feature and each embodiment described in the specific embodiment can be combined in any suitable way without contradiction. For example, different embodiments can be formed by the combination of different specific technical features/embodiments. In order to avoid unnecessary repetition, various possible combinations of each specific technical feature/embodiment in the present disclosure are not explained separately.

An LED lamp panel provided by an embodiment of the present disclosure includes a substrate and an LED chip. A circuit composite layer is disposed on the substrate. The circuit composite layer is provided with a bonding pad for connecting with the LED chip. A first reflective layer is disposed on the circuit composite layer. The first reflective layer is provided with a plurality of window structures. Each window structure has at least one pair of bonding pads in the corresponding area. The LED chip is disposed in the window structure and connected to the bonding pad in the corresponding window structure, and an accommodating area is formed between the outer periphery of the LED chip and the inner periphery of the window structure. The LED lamp panel further includes a second reflective layer filled in the accommodating area. Alternatively,

the circuit composite layer includes a circuit layer and a solder resist layer that is disposed on the circuit layer and has a window structure, each window structure has at least one pair of bonding pads in the corresponding area, the LED chip is disposed in the window structure and connected to the bonding pad in the corresponding window structure, the LED lamp panel further includes a first encapsulant layer that is disposed on one side of the substrate and covers the LED chip and the circuit composite layer and allows the light emitted by the LED chip to pass through, and the LED lamp panel further includes a second encapsulant layer that is disposed on the other side of the substrate and used for partially or completely offsetting the stress generated by the first encapsulant layer on the substrate. Alternatively,

the circuit composite layer includes a circuit layer and a solder resist layer that is disposed on the circuit layer and has a window structure, each window structure has at least one pair of bonding pads in the corresponding area, the LED chip is disposed in the window structure and connected to the bonding pad in the corresponding window structure, the LED chip is located in the window structure and connected to the circuit layer, the LED lamp panel further includes a colored glue layer, which is filled in the window structure and is respectively connected with the LED chip and the solder resist layer, and the color of the colored glue layer is the same as that of the solder resist layer, which is conducive to die bonding, improves the lighting effect, has a high preparation efficiency and a low manufacturing cost. The present disclosure will be further described and illustrated with reference to specific examples.

Embodiment 1

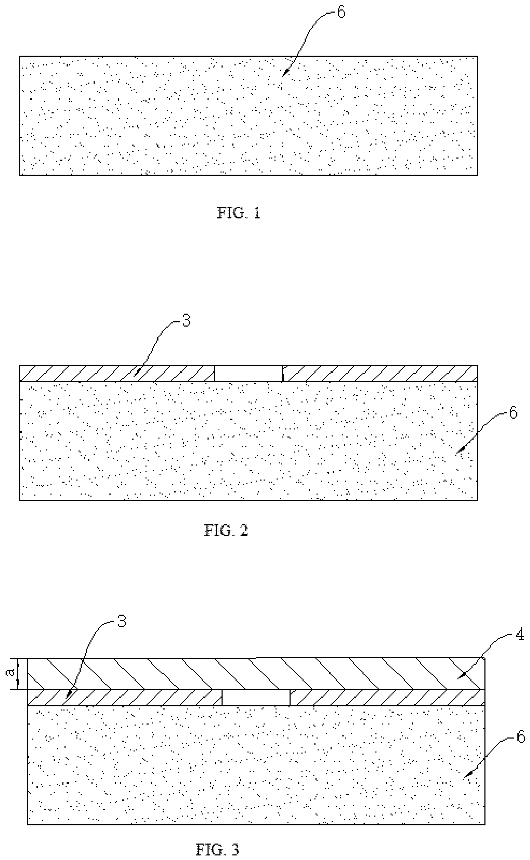

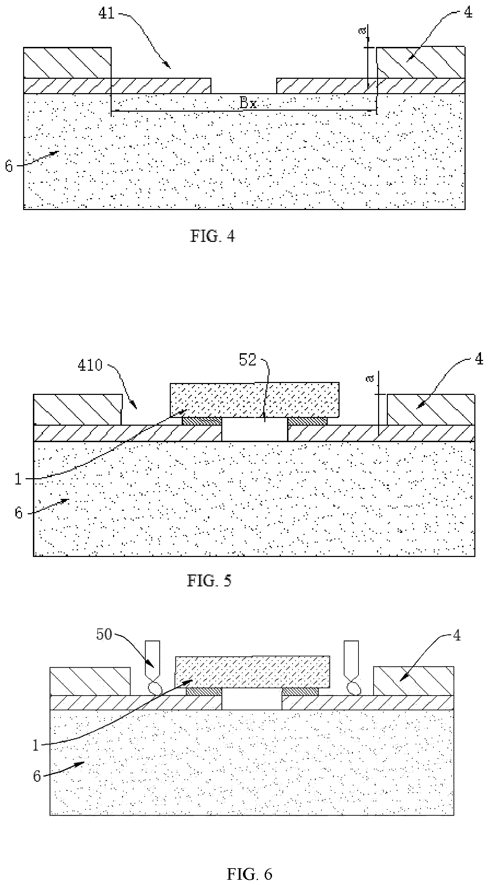

As shown in FIGS. 1 to 9, an LED lamp panel provided by an embodiment of the present disclosure includes a substrate and LED chips 1. In this embodiment, the substrate is a glass substrate 6 (as shown in FIG. 1), and a circuit composite layer 3 is disposed on the substrate. In this embodiment, the circuit composite layer includes a circuit layer 3, that is, a circuit layer 3 is disposed on the surface of the glass substrate 6, and a plurality of LED chips 1 are provided; the circuit layer 3 has at least one pair of bonding pads (as shown in FIG. 2) for cone ting with the plurality of LED chips 1; the circuit layer 3 is provided with a first reflective layer 4 (as shown in FIG. 3), and the lower surface of the first reflective layer 4 covers the circuit layer 3; the first reflective layer 4 is provided with a plurality of windowing structures 41 (as shown in FIG. 4), and the windowing structures 41 are holes penetrating through the first reflective layer 4. The LED chips 1 are disposed in the windowing structure 41 (as shown in FIG. 5) and connected to the bonding pads corresponding to the windowing structures 41. In this embodiment, all the window structures 41 are disposed in an array, and the window areas of the window structures 41 are larger than the projection areas of the LED chips 1 on the glass substrate 6, which exposes the position on the surface of the glass substrate 6 where the LED chips 1 need to be soldered and makes the LED chips 1 easy to be placed in the window structures 41. That is, the window structures 41 are disposed to expose the bonding pads, so as to prevent the bonding pads from being covered by the first reflective layer 4 and facilitate the welding of the LED chip 1 located in the windowing structure 41 with the corresponding bonding pad. If the gap between the window structure 41 and the LED chip 1 is too small, it is inconvenient for installation; if the gap is too large, it is easy for light to be leaked, which will affect the lighting effect and the process yield; since the size of the window structure 41 is larger than the external dimension of the LED chip 1, an accommodating area 410 is formed between the outer periphery of the LED chip 1 and the inner periphery of the window structure 41; the LED lamp panel further includes a second reflective layer 5, which is filled in the accommodating area 410 (as shown in FIG. 5). That is, the second reflective layer 5 is locate in the window structure 41, above the circuit layer 3, and on the periphery of the LED chip 1; the second reflective layer 5 is closely attached to the outer periphery of the LED chip 1, and the second reflective layer 5 is closely attached to the inner periphery of the window structure 41; the size of the window structure 41 is larger than that of the LED chip 1, so that the LED chip 1 can be easily placed in the window structure 41, with a high manufacturing efficiency and a low manufacturing cost, which facilitates in ensuring the yield of die bonding. Moreover, by using the second reflective layer 5 formed by filling, the accommodating area 410 can be well filled, and the light leakage gap can be avoided. The LED lamp panel provided by the embodiment of the present disclosure is conducive to die bonding, improves the lighting effect, and has a high preparation efficiency and a low manufacturing cost.

Further, the reflectivity of the second reflective layer 5 is greater than that of the first reflective layer 4, and the reflectivity of the second reflective layer 5 is higher than that of the first reflective layer 4. The second reflective layer 5 with higher reflectivity reflects more effective rays and has higher luminous efficiency; that is, the lighting effect is improved.

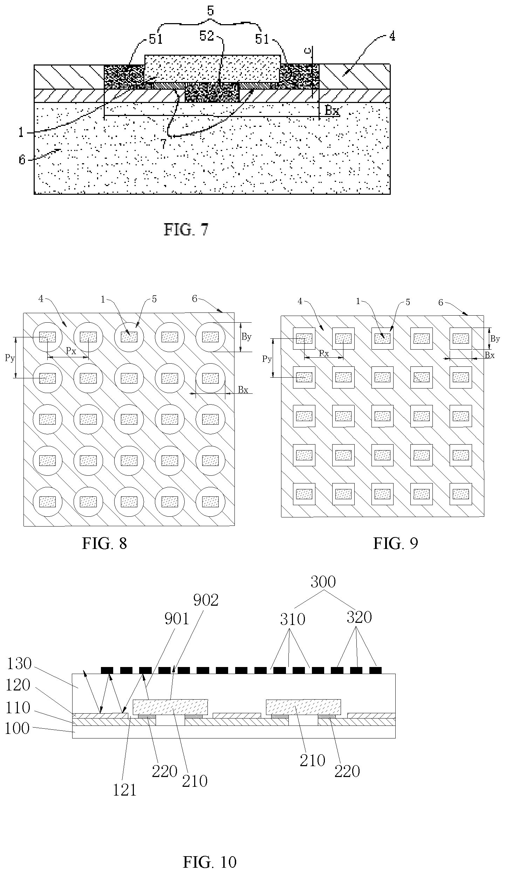

Further, the top surface of the first reflective layer 4 is between the bottom surface and the top surface of the LED chip 1, and the top surface of the second reflective layer 5 is not higher than the top surface of the first reflective layer 4. The thickness of the first reflective layer 4 may range from 20 $\mu$m to 80 $\mu$m. In specific applications, the second reflective layer 5 is filled in the accommodating area 410 between the LED chip 1 and the first reflective layer 4 (that is, in the window structure 41). The top surface of the second reflective layer 5 may be lower than the top surface of the first reflective layer 4 or kept flush with the top surface of the first reflective layer 4. In this embodiment, the second reflective layer 5 is formed by solidification of a colloid, which has certain fluidity and good filling effect. This avoids the occurrence of insufficient glue and light-leaking gaps. The thickness of the first reflective layer 4 is a (as shown in FIG. 3), and the thickness of the second reflective layer 5 is c (as shown in FIG. 7). In order to prevent colloid from overflowing to the upper surface of the first reflective layer 4, it is necessary to control the amount of the glue forming the second reflective layer 5 so that the thickness c of the second reflective layer 5 is less than or equal to the thickness a of the first reflective layer 4, thereby avoiding the colloid of the second reflective layer 5 from overflowing to the first reflective layer 4, which is conducive to ensuring the consistency of lighting effect of the LED lamp panel. The value of a may range from 20 $\mu$m to 80 $\mu$m, preferably from 25 $\mu$m to 60 $\mu$m, more preferably from 50 $\mu$m to 60 $\mu$m.

Further, the dimensions of the windowing structure 41 satisfy the following relationships: Bx < Px, By < Py; where Bx represents the largest dimension of the window structure in the transverse direction, By represents the largest dimension of the window structure in the longitudinal direction, Px represents the transverse spacing between two adjacent LED chips 1, and Py represents the longitudinal spacing between two adjacent LED chips 1. In specific applications, the window structure 41 is rectangular, and its largest dimension is the length of the rectangular, as shown in FIG. 9, that is, the windowing structure 41 may be a rectangular slot, and the shape of the LED chips 1 can be rectangular, with the pitch between the centers of two adjacent LED chips 1 being p (as shown in Figures 8 and 9), and the transverse distance between the centers of two adjacent LED chips 1 being Px and the longitudinal distance between the centers of two adjacent LED chips 1 being Py. The maximum transverse dimension of the window structure 41 is Bx, and the maximum longitudinal dimension thereof is By (as shown in figs. 8 and 9), where Bx < Px, and By < Py. The accommodating area 410 may be in a "homocentric squares" shape, and the length dimension of the rectangle Bx is ≥ 2mm; preferably, Bx is ≥ 3mm. In another embodiment, as shown in FIG. 8, the window structure 41 may also be in the shape of a circular hole, in which case its largest dimension is its diameter, and the diameters are all smaller than Px and Py. It can be ensured that the window opening area of the window structure 41 is larger than the projection area of the LED chip 1 on the glass substrate 6, which is conducive to exposing the position on the surface of the glass substrate 6 where the LED chip 1 needs to be soldered. The LED chip 1 may be disposed in the center of the window structure 41, and adjacent window structures 41 are not connected, which is conducive to production and cost control.

Further, the LED chip 1 may be a flip chip, there is a gap between the side of the LED chip 1 facing the glass substrate 6 and the glass substrate 6, and the second reflective layer 5 includes a side reflective part 51 and a bottom reflective part 52. As shown in FIG. 7, the side reflective part 51 is joined with the periphery of the LED chip 1, and the bottom reflective part 52 is filled in the gap and joined with the bottom surface of the LED chip 1.

Further, the surface of the bonding pad is provided with a solder paste layer 7, and the metal solder paste of the solder paste layer 7 is gray and absorbs blue light. The LED chip 1 is connected to the bonding pad through the solder paste layer 7, forming the above-mentioned gap filled by the bottom reflective part 52. The solder paste layer 7 is used to connect with the LED chip 1. Specifically, the solder paste is printed on the bonding pad, and the LED chip 1 is soldered on the bonding pad, thereby completing die bonding; the top surface of the first reflective layer 4 is between the bottom surface and the top surface of the LED chip 1. Light will be blocked if the first reflective layer 4 is higher than the top surface of the LED chip 1, and the first reflective layer 4 is lower than the bottom surface of the LED chip 1 to expose the solder paste layer 7. In this embodiment, the LED chip 1 is connected to the bonding pad through a solder paste layer 7 (metal solder paste), and the metal solder paste is gray. The bottom reflective part 52 located at the bottom of the LED chip 1 may be coated on the metal solder paste layer 7, so that blue light can be prevented from being absorbed by the solder paste layer 7.

Further, the first reflective layer 4 may be made of white ink. The second reflective layer 5 is made of silica gel or silicone resin, and reflective particles are dispersed in the second reflective layer 5. In specific applications, the second reflective layer 5 contains at least one of $TiO_2$ reflective particles and $BaSO_4$ reflective particles; that is, a certain amount of reflective particles are mixed into the glue material, which is conducive to further improving the reflectivity of the second reflective layer 5; the reflective layer of the LED lamp panel may adopt a combination of with white ink and white glue, and both white glue and white ink can be used as reflective materials. The white ink has a low cost, but a low reflectivity and a poor fluidity and is applicable for large-area printing. However, white glue is expensive, has high reflectivity and strong fluidity, and is generally used for local gap dispensing in the prior art; in this embodiment, the first reflective layer 4 is made of white oil (white ink), which is low in cost, while the second reflective layer 5 is made of white glue, which has good fluidity and good filling effect. The reflectivity of the first reflective layer 4 is generally not higher than 93%, while the reflectivity of the second reflective layer 5 is not lower than 98%, which solves all of the problems of difficult die bonding, low lighting effect, and high cost. In the traditional method, easy die bonding, high lighting effect and low cost are contradictory constraints, and at least one of them must be sacrificed, therefore it is impossible to achieve easy die bonding, high lighting effect and cost at the same time. However, the LED lamp panel provided by the present disclosure realizes easy die-bonding, improves the lighting effect at the same time, has high efficiency and low cost, ensures easy die bonding and high lighting effect while taking the cost into consideration, has strong operability in actual production, and thus has a high market application value.

Referring to FIGS. 1 to 9, an embodiment of the present disclosure also provides a manufacturing method of an LED lamp panel, which is used for manufacturing the LED lamp panel and includes the following steps.

As shown in FIG. 1, a substrate is prepared. In this embodiment, a glass substrate 6 is used, which has a good stability and a low cost.

As shown in FIG. 2, a circuit layer 3 with bonding pads is provided on the substrate. Specifically, the circuit layer 3 is printed on the substrate, and the circuit layer 3 has bonding pads for connecting with a plurality of LED chips 1.

As shown in FIG. 3, a first reflective layer 4 made of a first reflective material is provided on the circuit layer 3. Specifically, in this embodiment, white ink is printed on the circuit layer 3 to form the first reflective layer 4.

As shown in FIG. 4, the first reflective layer 4 is provided with a plurality of window structures 41, so that there is at least one pair of bonding pads in the area of each of the window structures 41. Specifically, in this embodiment, the window structure 41 is formed by an exposure etching process. The first reflective layer 4 is provided with a plurality of window structures 41 disposed in a matrix. In this embodiment, the window structures 41 are rectangular slots (as shown in FIG. 7), and in another embodiment, the window structures 41 can also be circular holes (as shown in FIG. 8).

As shown in FIG. 5, the LED chip 1 is disposed in the window structure 41, and the LED chip 1 is connected with the bonding pads. Specifically, the bonding pads corresponding to the same LED chip 1 are also located in the window structure 41, that is, the LED chips 1 located in the window structure 41 are connected with the corresponding pads, and two or more LED chips 1 can also be disposed in each window structure 41.

As shown in FIG. 6, a second reflective material 50 (in this embodiment, the reflectivity of the second reflective material 50 is greater than that of the first reflective material) is filled in the window structure 41, and the second reflective material 50 is located between the first reflective layer 4 and the LED chip 1 to form a second reflective layer 5, as shown in FIG. 7. Specifically, in this embodiment, white glue is used as the second reflective material 50.

An embodiment of the present disclosure provides an LED lamp panel and a manufacturing method thereof. The circuit layer 3 is provided with a first reflective layer 4, which is provided with a plurality of window structures 41. The LED chip 1 is disposed in the window structures 41 and connected to the bonding pads corresponding to the window structure 41. An accommodating area 410 is formed between the outer periphery of the LED chip 1 and the inner periphery of the window structure 41. Filling the accommodating area with the second reflective layer 5 with a high reflectivity is conducive to die bonding, and the manufacturing cost is low. The reflectivity of the second reflective layer 5 is greater than that of the first reflective layer 4, so that the lighting effect can be improved. The LED lamp panel and the manufacturing method thereof provided by the present disclosure are not only conducive to die bonding but also improve the lighting effect, improve the process yield, and have low manufacturing cost.

Embodiment 2

As shown in FIG. 10, an LED lamp panel provided by an embodiment of the present disclosure is a backlight board, including a substrate 100, a circuit layer 110 and a plurality of LED chips. The LED chips are light-emitting chips 210, one side of the circuit layer 110 is disposed on the substrate 100, and the light-emitting chips 210 are disposed on the other side of the circuit layer 110. The backlight board further includes an encapsulant layer 130 and a plurality of reflection patterns 300. The encapsulant layer 130 covers the substrate 100 and the light-emitting chips 210, and the reflection patterns 300 are disposed on the upper surface of the encapsulant layer 130. The light emitting surface of the light-emitting chip 210 faces the reflection patterns 300, and the reflection patterns 300 include a plurality of reflection units 320 disposed at intervals. A gap 310 (which can be an air gap) is formed between the reflection units 320. The reflection unit 320 includes resin and reflective particles dispersed in the resin. The reflective particle density in the central area of the reflection pattern 300 is greater than that in the peripheral area of the reflection pattern 300, and the reflection pattern 300 can reflect part of the light emitted from the light emitting surface of the light-emitting chip 210. The backlight board further includes a first reflective layer, which, in this embodiment, is a reflective layer 120. The reflective layer 120 (a first reflective layer) can be a white glue layer, and reflective particles can be embedded in the reflective layer 120 (the first reflective layer) in a dispersed manner. The reflective layer 120 (the first reflective layer) is disposed on the side of the circuit layer 110 connected with the light-emitting chips 210, and one side (back side) of the encapsulant layer 130 covers the reflective layer 120 (the first reflective layer) and the light-emitting chips 210 (LED chips).

The reflection units 320 are the reflection area 320 (for reflecting light), and the air gap 310 is the hollowed-out area (for light to pass through). Some of the light emitted by the light-emitting chips 210 (LED chips) is directed to the reflection area (901 in FIG. 10), and some of it is directly emitted from the hollowed-out area (as 902 in FIG. 10). The light directed to the reflection area is reflected by the reflection area to form reflected light. Part of the reflected light is reflected by the reflective layer and then emitted from the hollowed-out area and the side of the light-emitting chip 210. In view of the characteristics of strong light emission in the central part of the LED chip and weak light emission in the peripheral part, in this embodiment, the hollowed-out area is formed by providing a hollowed-out structure on the reflection pattern 300, so that the proportion and distribution of the hollowed-out areas can be modulated to make the reflection particle density in the central area of the reflection pattern 300 greater than that in the peripheral area, so as to weaken the light intensity emitted from the encapsulant layer 130 in the central area of the front face of the light-emitting chip 210 and increase the light intensity emitted from the encapsulant layer 130 in the lateral area of the light-emitting chip 210. Part of the light emitted by the light-emitting chip 210 can be directly emitted from the front face through the hollowed-out area, and part of the light is reflected by the reflection area, which can effectively modulate the brightness above the light-emitting chips 210 (i.e. the front, which refers to the front in the light-emitting direction of the light-emitting chips 210), and ensure the lighting effect and brightness of the backlight board. Meanwhile, under the local reflection of the reflection patterns 300, part of the light is reflected to the area on the side of the light-emitting chip 210, so that the light-emitting angle of the light-emitting chip 210 after passing through the encapsulant layer 130 is increased, the brightness of the light-emitting chip 210 at the peripheral area is improved, the light-emitting uniformity of the light-emitting board is improved, and the application effect is good.

Specifically, the light-emitting chip 210 may be a MINI LED flip-chip, which is soldered to the circuit layer 110 through the bonding pad 220. Specifically, the reflective layer 120 (the first reflective layer) may be provided with a void-avoiding window (avoidance window) 121 corresponding to the light-emitting chip 210, and the encapsulant layer 130 may be filled in the gap between the void-avoiding window 121 and the light-emitting chip 210. The reflection pattern 300 is disposed on the other surface (the front surface) of the encapsulant layer 130. Alternatively, the reflection pattern 300 is embedded in the encapsulant layer 130; that is, the reflection pattern 300 can also be sandwiched in the encapsulant layer 130 to form a sandwich structure, and the reflection pattern 300 can be protected by the encapsulant layer 130 to prevent accidental damage. In this embodiment, the reflection pattern 300 can be formed on the other surface (the front surface) of the encapsulant layer 130 by stencil screen printing. The process is simple and reliable, and the hollowing-out size and hollowing-out ratio can be accurately controlled, with a good product consistency, a high production efficiency and a low cost.

Specifically, in one of the reflection patterns 300, the area of the air gap 310 (a hollowed-out area) can account for 20% to 80% of the area of the outline of the reflection pattern 300, which is conducive to ensuring the lighting effect and light-emitting uniformity. In specific applications, the area of the air gap 310 can account for 30% to 60% of the area of the outline of the reflection pattern 300, which can improve the lighting effect and brightness of the backlight board and ensure the uniformity of light emission of the backlight board.

In specific applications, the thickness of the reflection pattern 300 can be 10 μm to 60 μm, which has a good reflection effect and a low application cost.

In specific applications, the reflection pattern 300 can be made of white glue; that is, the white glue is silk-printed into the reflection pattern 300 with a hollowed-out area. The white glue may be white silicone.

Alternatively, the reflection pattern 300 may include white glue (white silicone) and reflective particles embedded in the white glue, and the reflective particles may be titanium dioxide reflective particles or/and silicon dioxide reflective particles to improve the reflective efficiency of light. In this embodiment, the reflectivity corresponding to the reflection area of the reflection pattern 300 is ≥88%.

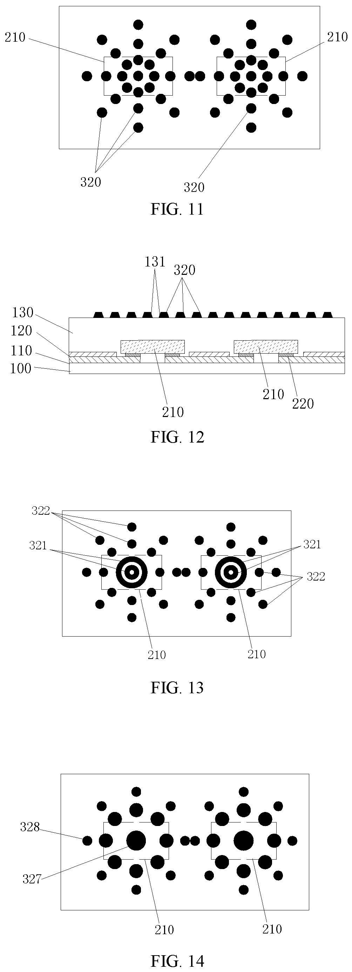

Specifically, the reflection units 320 may include a reflection area with a point structure (as shown in FIG. 10), a block structure, a linear structure, a grid structure or a ring structure. In specific applications, the reflection units 320 can be in the shape of a dot, a ring (as shown in FIG. 13), a polygon, a polygonal ring (a hollowed-out polygon), a straight line, a wavy line, a folded line, etc., and the reflection area can also be in the shape of a rectangular grid, a rhombic grid, and the like.

In specific applications, as shown in FIG. 10, the density of the reflection area near the center of the light-emitting chip 210 (LED chip) can be greater than that of the reflection area far away from the center of the light-emitting chip 210; that is, the reflection areas are relatively dense center (referring to the center of the light-emitting chip 210) and relatively spare periphery, which can effectively modulate the brightness above the light-emitting chip 210, reinforce the brightness of the periphery of the light-emitting chip 210 (LED chip), and make the lighting effect uniform.

Specifically, the hollowed-out area may include a hollowed-out area with a point structure, a linear structure, a grid structure or a ring structure. In specific applications, the hollowed-out area can be dot-shaped, circular-shaped, polygonal, polygonal-shaped, straight-shaped, wavy-shaped, folded-shaped, etc., and the hollowed-out area can also be rectangular-shaped, rhombic-shaped, etc.

In specific applications, as shown in FIG. 11, the density of the hollowed-out area near the center of the light-emitting chip 210 (LED chip) can be less than that of the hollowed-out area far away from the center of the light-emitting chip 210; that is, the air gaps are relatively sparse in the center (referring to the center of the light-emitting chip 210) and relatively dense on the periphery, which can effectively modulate the brightness above the light-emitting chip 210, reinforce the brightness on the periphery of the light-emitting chip 210, and make the lighting effect uniform.

Of course, in some embodiments, the air gaps may also be set randomly or uniformly.

Specifically, there are one or at least two light-emitting chips 210 (LED chips), and the reflection areas include a central reflection area and peripheral reflection areas. The central reflection area is disposed right above each light-emitting chip 210, and the peripheral reflection areas are disposed at the periphery of the central reflection area. The density of the reflection areas in the central reflection area is greater than that of the peripheral reflection areas, which is conducive to modulating the brightness above the light-emitting chip 210, reinforcing the brightness around the light-emitting chip 210, and making the lighting effect uniform.

As an optional solution of the reflection area, as shown in FIG. 13, the reflection units 320 include a plurality of concentrically disposed reflection rings 321, and there are spacings between adjacent reflection rings 321, with the areas corresponding to the spacings being air gaps. The reflection ring 321 may be a circular ring or a polygonal ring. The spacing between adjacent reflection rings 321 can be equal, or the spacing size near the center of the reflection ring group can be smaller than that far away from the center of the reflection ring group. The reflection rings 321 can be annular, and the larger the radius of the reflection ring 321, the larger the spacing between its outer side and the adjacent reflection ring 321, so as to match the light-emitting characteristics of the light-emitting chip 210 (LED chip) with strong light emission at the center and weak light emission at the edge. The light emitted by the reflective layer 120 (the first reflective layer) is more uniform to modulate the brightness above the light-emitting chip 210, reinforce the brightness of the periphery of the light-emitting chip 210, and make the uniformity of lighting effect better.

Specifically, the dotted box shows the light-emitting chips 210 (LED chips), and each light-emitting chip 210 is correspondingly provided with the reflection ring group right in front of the light-emitting direction, and the center of the reflection ring group corresponds to the center of the light-emitting chip 210, so that the brightness above the light-emitting chip 210 can be well modulated.

Specifically, the periphery of the reflection ring can be provided with a scattered reflection structure, which is in the shape of a dot, a strip or a ring; that is, the scattered reflection structure can be a reflection point. In specific applications, the scattered reflection structures are uniformly distributed, or the density of each scattered reflection structure decreases with the distance from the center of the reflection pattern 300, which is conducive to reinforce the brightness of the periphery of the light-emitting chip 210 (LED chip) and make the uniformity of lighting effect better. In specific applications, the scattered reflection structure can be reflection points 322, and the reflection points 322 can be distributed in the circumferential direction at intervals. The reflection points 322 can be circular or polygonal, and they can be evenly spaced along the circumferential direction of one or at least two concentric circles (concentric with the reflection ring 321), and the larger the radii of the concentric circles, the larger the spacing of the reflection points 322 in the circumferential direction, that is, the larger the radius of the concentric circles, and the less the number of reflection points 322 on the concentric circle (not shown). In this embodiment, according to the light intensity distribution curve of the backlight board (not shown), the brightness above the chip can be effectively modulated through the reflection patterns 300, which is conducive to improving the light emitting uniformity of the backlight board.

As one of the optional solutions, the air gap may include a hollowed-out ring group, which includes a plurality of hollowed-out rings disposed concentrically, and there is a spacing between adjacent hollowed-out rings; the hollowed-out rings can be circular rings or polygonal rings. The spacings between adjacent hollowed-out rings may be equal, or the spacing near the center of the hollowed-out ring group may be larger than the spacing far away from the center of the hollowed-out ring group, so as to modulate the brightness above the light-emitting chip 210 (LED chip), reinforce the brightness around the light-emitting chip 210, and make the lighting effect uniformity better.

As one of the optional solutions, the reflection area includes strip-shaped reflection bands and reflection points, and the reflection points are located at the periphery of the reflection bands (that is, the area near the center of the light-emitting chip 210 (LED chip)). In the circumferential direction, the reflection bands are distributed in a continuous strip shape, and in the peripheral area of the light-emitting chip 210, the reflection points can be distributed at intervals in the circumferential direction. Each light-emitting chip 210 is correspondingly provided with the reflection bands right in front of the light emitting direction. A plurality of reflection bands are disposed, and the reflection bands can be disposed at intervals or/and intersected. The reflection points are circular or polygonal to modulate the brightness above the light-emitting chip 210, reinforce the brightness around the light-emitting chip 210, and make the uniformity of the lighting effect better.

In specific applications, the reflection points are evenly distributed, or the area of the reflection points decreases with the distance from the center of the reflection pattern, which is conducive to reinforcing the brightness around the light-emitting chip 210 and making the lighting effect more uniform.

In a specific application, the reflection units 320 include a plurality of reflection points around the center of the reflection pattern 300.

In specific applications, the encapsulant layer 130 may be a transparent glue layer to avoid light loss.

Specifically, the thickness of the encapsulant layer 130 may be 200 $\mu$m to 400 $\mu$m, and the light has a certain reflection distance and space, which is conducive to improving the lighting effect.

In specific applications, as shown in FIG. 12, the sidewalls of the reflection units 320 can be optionally provided with demoulding inclined planes 131, which are convenient for demoulding the screen and is conducive to improving the yield of products.

In specific applications, as shown in FIG. 14, the reflection area includes a plurality of reflection blocks (which may in a shape of blocks), and the area of each reflection block can be reduced in the direction away from the center of the light-emitting chip 210. The closer each reflection block is to the light-emitting chip 210, the larger its single area is. That is, the reflection block includes a central block 327 close to the light-emitting chip 210 and peripheral blocks 328 located at the periphery of the central block 327, and the size of the central block 327 is larger than that of the central blocks 327, so as to effectively modulate the brightness above the light-emitting chip 210, reinforce the brightness at the periphery of the light-emitting chip 210, and make the lighting effect uniform.

In specific applications, as shown in FIGS. 10, 11 and 14, the reflectivity of the reflection units 320 in the central area of the reflection pattern 300 is greater than that of the reflection units 320 in the peripheral area of the reflection pattern 300. The reflection units 320 in the central region of the reflection pattern 300 contain titanium dioxide particles, and the reflection units 320 in the peripheral region of the reflection pattern 300 contain silicon dioxide particles. The part of the reflection area close to the light-emitting chip 210 may be provided with titanium dioxide particles, and the part of the reflection area far away from the light-emitting chip 210 may be provided with silicon dioxide particles.

In specific applications, as an alternative, the reflective block includes a central block 327 close to the light-emitting chip 210 and peripheral blocks 328 located at the periphery of the central block 327. The reflectivity of the central block 327 is greater than that of the peripheral block 328, the central block 327 may be provided with titanium dioxide particles, and the peripheral block 328 may be provided with silicon dioxide particles. The central block 327 can be larger than or equal to the size of the peripheral block 328, so as to effectively modulate the brightness above the light-emitting chip 210, reinforce the brightness at the periphery of the light-emitting chip 210, and make the lighting effect uniform.

Specifically, the backlight board may optionally include a transparent second encapsulant layer and a second hollowed-out reflective layer for allowing some light rays to pass through. One side of the second encapsulant layer covers the reflection pattern 300 and the encapsulant layer 130, and the second hollowed-out reflective layer is disposed on the other side of the second encapsulant layer. The projection of the air gap of the second hollowed-out reflective layer and that of the air gap of the reflection pattern 300 on the substrate 100 at least partially overlaps, that is, the light of the light-emitting chip 210 can be modulated through reflection by two or more layers, which is conducive to improving the uniformity of light emission. The material and thickness of the second hollowed-out reflective layer and the reflection pattern 300 may be the same. In this embodiment, only one encapsulant layer and one hollowed-out reflective layer are used.

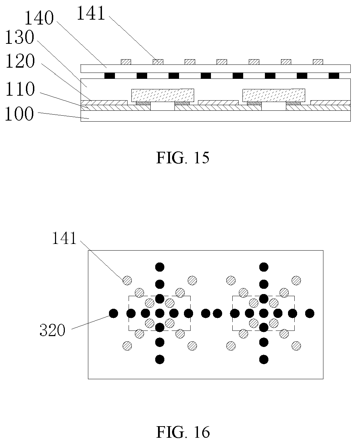

In specific applications, as shown in FIG. 15 and FIG. 16, an optical film 140 can be installed on the lamp panel. The optical film 140 may be located above the encapsulant layer 130, and diffusion patterns 141 may be printed on the surface of the optical film 140. The diffusion patterns 141 and the reflection patterns 320 of the optical film 140 can be staggered, and part of light will be reflected back and forth between the staggered diffusion patterns 141 and the reflection patterns 320 and then emitted out, which is conducive to light uniformity. The diffusion pattern 141 may have the same structure as the reflection pattern 320; that is, it includes resin and reflective particles dispersed in the resin.

In the above embodiment, the reflection pattern can also be disposed on a single optical film and then pasted on the encapsulant layer, so that optical films with different reflection patterns can be prefabricated, and the optical film with specific reflection patterns can be selected and pasted on the encapsulant layer according to the application effect. Moreover, the optical film may be replaced, which is flexible and convenient to use and has a wide application range. In addition, the diffusion pattern and the reflection pattern may also be screen-printed on the front and back of the same optical film (that is, the diffusion pattern and the reflection pattern share one optical film as a carrier without disposing two optical films), and the diffusion patterns and the reflection patterns can be staggered, so that the optical film can be directly attached to the encapsulant when in use, which is flexible and convenient to use, wide in application range and low in cost.

This embodiment also provides a manufacturing method of the LED lamp panel, which is used for manufacturing the backlight lamp panel and include the following step:

a substrate 100 is prepared;
a circuit layer 110 is disposed on the substrate 100;
a light-emitting chip 210 (LED chip) is connected to the circuit layer 110, and a reflective layer 120 (a first reflective layer) may be disposed on the circuit layer 110;
the light-emitting chip 210 (LED chip) and the reflective layer 120 (the first reflective layer) are covered with an encapsulant layer 130; and

reflection patterns 300 for allowing part of light to pass through and reflecting part of light are disposed on the encapsulant layer 130 such that the reflection surface of the reflection patterns 300 faces the light-emitting surface of the light-emitting chip 210. Part of the light emitted by the light-emitting chip 210 is emitted to the reflection area, and part of it directly penetrates through the air gap. The light emitted to the reflection area is reflected by the reflection area to form reflected light, part of the reflected light is reflected by the reflective layer 120 (the first reflective layer) and emitted from the air gap at the periphery of the light-emitting chip 210 and the side surface, and part of the reflected light is reflected and emitted from the side surface of the light emitting chip 210. According to the characteristics of strong light emission at the center of the light-emitting chip 210 and weak light emission at the periphery, in this embodiment, a hollowed-out structure is formed on the reflection pattern 300 to form an air gap, which can modulate the proportion and proportion of the air gap area, weaken the light intensity in the central area of the front face of the light-emitting chip 210, and increase the light intensity in the lateral area of the light-emitting chip 210, so that part of the light emitted by the light-emitting chip 210 can directly pass through the air gap and be emitted from the front face, while part of the light is reflected by the reflection area, which can effectively modulate the brightness above the light-emitting chip 210 (that is, right in front of the light-emitting direction) and ensure the lighting effect and brightness of the backlight board. At the same time, under the action of the reflection pattern 300 and the reflective layer 120 (the first reflective layer), the light-emitting angle of the light-emitting chip 210 is increased, and the brightness of the light emission around the light-emitting chip 210 is improved, which has a good application effect.

Specifically, the reflection pattern 300 is printed on the surface of the encapsulant layer 130 by screen printing. The process is simple and reliable, and the hollowing size, hollowing ratio, etc. can be accurately controlled, with a good product consistency, a high production efficiency, and a low cost.

The LED lamp panel provided by the embodiment of the present disclosure is a backlight lamp panel. By disposing the reflection patterns 300, part of the light emitted by the light-emitting chip 210 can be emitted from the front of the reflection pattern 300 through the air gap in front of the light-emitting chip 210, while part of the light is emitted to the reflection area and reflected by the reflection area to form reflected light. Part of the reflected light is reflected by the reflective layer 120 (the first reflective layer) and then emitted from the air gap around the light-emitting chip 210 and the side surface, while part of the reflected light is reflected and emitted from the side surface of the light-emitting chip 210. In view of the characteristics of strong light emission at the center of the light-emitting chip 210 and weak light emission at the periphery, in this embodiment, an air gap is formed by opening a hollowed-out structure on the reflection pattern 300, so that the proportion and proportion of the air gap area can be modulated. Weakening the light intensity in the center area of the front of the light-emitting chip 210 and increasing the light intensity in the lateral area of the light-emitting chip 210 can make part of the light emitted by the light-emitting chip 210 directly exit from the front through the air gap and part of it be reflected by the reflection area, which can effectively modulate the brightness above the light-emitting chip 210 (that is, in front, right in front of the light-emitting direction) and ensure the lighting effect and brightness of the backlight board. At the same time, under the action of the reflection patterns 300 and the reflective layer 120 (the first reflective layer), the light-emitting angle of the light-emitting chip 210 is increased, and the brightness of the peripheral light of the light-emitting chip 210 is improved, so that the light-emitting uniformity of the lamp panel is improved, and the application effect is good.

Embodiment 3

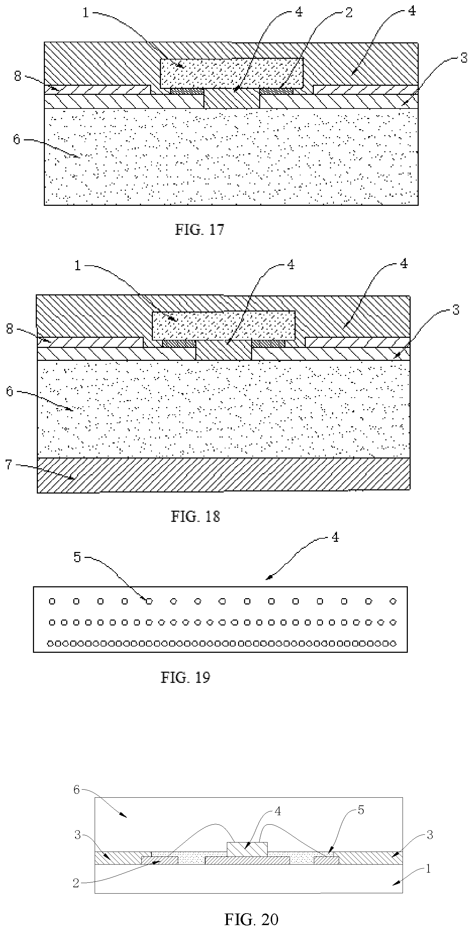

As shown in FIG. 17 and FIG. 18, and referring to FIG. 1 to FIG. 3, an LED lamp panel provided by an embodiment of the present disclosure can be used for Mini LED backlight display modules and direct view products. The lamp panel includes a substrate 6, a first encapsulant layer 4, a circuit composite layer, and LED chips 1. The circuit composite layer includes a circuit layer 3 and a solder resist layer 8, and the solder resist layer 8 is disposed on the circuit layer 3 and has a window structure. The solder resist layer 8 is disposed between the circuit layer 3 and the first encapsulant layer 4 and is provided with a plurality of window structures. The circuit layer 3 is disposed on one side of the substrate 6, and the circuit layer 3 has a bonding pad. The LED chips 1 are connected to the bonding pad. In this embodiment, the LED chip 1 is a flip chip, specifically a flip blue LED chip or a flip RGB LED chip set. The substrate 6 may be an FR4 circuit substrate or a glass substrate. The lamp panel further includes a second encapsulant layer 7, the first encapsulant layer 4 is disposed on one side of the substrate 6 and covers the LED chips 1 and the circuit layer 3, and the first encapsulant layer 4 allows the light emitted by the LED chip 1 to pass through. The second encapsulant layer 7 is disposed on the other side of the substrate 6 to partially or completely offset the stress generated by the first encapsulant layer 4 on the substrate 6. It should be noted that if the first encapsulant layer 4 is formed by dispensing or molding only with the first encapsulant, the first encapsulant layer 4 has a stress acting on the substrate 6, which makes the substrate 6 easy to deform, which is usually expressed as the two ends of the substrate 6 being warped and the middle part thereof being concave, causing the LED chips 1 to be easily peeled off. In this embodiment, the first encapsulant layer 4 and the second encapsulant layer 7 are respectively disposed on two sides of the substrate 6, and a sandwich structure is formed with the substrate 6 through the first encapsulant layer 4 and the second encapsulant layer 7. The first encapsulant layer 4 has a tensile stress acting on the substrate 6 and facing one side of the substrate 6, and the second encapsulant layer 7 has a tensile stress acting on the substrate 6 toward a side of the substrate 6, so that the tensile stress acting on both sides of the substrate 6 can be offset to a great extent. The warpage and deformation in the substrate 6 (especially the substrate 6) caused by the stress exerted by the encapsulant layer are effectively reduced, the problems of delamination, deformation, poor air tightness, and the like of the lamp panel after encapsulation are effectively improved, and adverse risks such as peeling of the LED chip 1 are avoided. Moreover, the first encapsulant layer 4 and the second encapsulant layer 7 form a sandwich structure with the substrate 6, without the need for multiple encapsulant layers, therefore the manufacturing process is simple and the cost is low.

In specific applications, the projection area of the first encapsulant layer 4 on the substrate 6 can cover the substrate 6; that is, the first encapsulant layer 4 can completely cover the surface of one side of the substrate 6. Alternatively, the first encapsulant layer 4 can be composed of first unconnected segmented glue layers, and the first encapsulant is molded on one side of the substrate 6 (specifically, one side of the circuit layer 3 and the top of the LED chip 1) by glue dispensing to form a plurality of unconnected first segmented glue layers. In another embodiment, the second encapsulant layer 7 may also be composed of second unconnected segmented glue layers, and the second encapsulant is molded on the other side of the substrate 6 by glue dispensing to form a plurality of segments of the second unconnected segmented glue layers, so as to offset the stress between the substrates 6 located on the two sides of the segmented glue layers and prevent the substrate 6 from being deformed. As an alternative embodiment, the first encapsulant layer 4 can completely cover one side of the substrate 6, and the second encapsulant layer 7 can partially cover the other side of the substrate 6, so that the back of the substrate 6 can reserve space for installing other components.

In specific applications, the thickness of the first encapsulant layer 4 is not less than the thickness of the second encapsulant layer 7. Specifically, the first encapsulant layer 4 located on one side of the substrate 6 can protect the LED chip 1 and requires a certain thickness. The second encapsulant layer 7 located on the other side of the substrate 6 has an additional thickness, which will increase the overall thickness of the product, which is not in line with the market trend of the overall thinning of LED modules. By controlling the thickness of the second encapsulant layer 7 to be smaller than that of the first encapsulant layer 4, it is conducive to the overall thinning of the lamp panel and the miniaturization of the device, which can meet the market demand.

In specific applications, the thickness of the first encapsulant layer 4 is greater than that of the second encapsulant layer 7. The first encapsulant layer 4 has a first thermal expansion coefficient, and the second encapsulant layer 7 has a second thermal expansion coefficient, which is greater than the first thermal expansion coefficient. The product of the thickness of the first encapsulant layer 4 and the first thermal expansion coefficient is A, and the product of the thickness of the second encapsulant layer 7 and the second thermal expansion coefficient is B, where A is equal to or roughly equal to B. It should be explained that the thickness of the first encapsulant layer 4 is relatively large and the first thermal expansion coefficient is relatively small, while the thickness of the second encapsulant layer 7 is relatively small and the first thermal expansion coefficient is relatively large, so that the stresses acting on both sides of the substrate 6 can be balanced and offset. At the same time, the first encapsulant layer 4 can have a certain thickness to protect the LED chip, while the thickness of the second encapsulant layer 7 can be relatively small, which is conducive to the thinning of the lamp panel. As another embodiment, the thickness of the first encapsulant layer 4 is equal to that of the second encapsulant layer 7, the first encapsulant layer 4 has a first thermal expansion coefficient, and the second encapsulant layer 7 has a second thermal expansion coefficient, which is the same as the first thermal expansion coefficient. In specific applications, the most important parameters of the stress of the encapsulant layer on the substrate 6 are the thickness and thermal expansion coefficient of the encapsulant layer. In specific applications, encapsulant materials with different thermal expansion coefficients can be selected according to the thickness of the encapsulant layer, and the regulation and control are flexible, so that the stress acting on both sides of the substrate 6 can be offset and the whole product tends to be thinner.

Further, the first encapsulant layer 4 and the second encapsulant layer 7 are made of the same material, both of which are epoxy resin or silicone resin, which is conducive to reducing the cost. In another embodiment, the materials of the first encapsulant layer 4 and the second encapsulant layer 7 may also be different. The first encapsulant layer 4 is dispersedly provided with inorganic light-transmitting particles 5 for adjusting its thermal expansion coefficient, and the thermal expansion coefficient of the encapsulant layer can be adjusted by adding the inorganic light-transmitting particles into the encapsulant layer, so that the adjustment is convenient and the cost is low. The settling of the inorganic light-transmitting particles 5 in the first encapsulant layer 4 makes the content of the inorganic light-transmitting particles 5 gradually decrease along the direction away from the substrate 6, that is, the added inorganic light-transmitting particles 5 naturally settle in the first encapsulant, and the closer the area is to the substrate 6, the smaller its thermal expansion coefficient, which can effectively reduce the deformation of the substrate 6. The particle size of the inorganic light-transmitting particles 5 ranges from 50 nm to 5 $\mu$m. Inorganic light-transmitting particles 5 can transmit light, which is conducive to ensuring the light emission of LED chips. In this embodiment, the inorganic light-transmitting particles 5 are silica powder or alumina powder, or a mixture of silica powder and alumina powder, and the inorganic light-transmitting particles 5 are added into the first encapsulant layer 4. In this embodiment, it is preferable that the particle size of the inorganic light-transmitting particles 5 ranges from 100 nm to 1 $\mu$m, silica is the main component of glass, alumina is the main component of sapphire, silica powder and alumina powder are light-transmitting particles, and the doping ratio of silica powder or alumina powder in the first encapsulant layer 4 is 20% to 60%. By controlling the standing time of the first encapsulant before curing, the silica powder or alumina powder naturally settles in the first encapsulant and presents a stepped distribution, so that the closer to the substrate 6, the higher its content, that is, the smaller its thermal expansion coefficient, which further reduces the deformation of the substrate 6. In addition, the projection area of the encapsulant layer located at the other side of the substrate 6 on the substrate 6 can be flexibly adjusted, and it may not cover the other side of the substrate 6 completely due to cost factors. The adoption of light-transmitting particles does not affect the light emission of the LED chip 1, and the thermal expansion coefficient is adjusted, so that the adjustment effect is good and the cost is low.

As an alternative embodiment, the thickness of the first encapsulant layer 4 ranges from 150 $\mu$m to 400 $\mu$m, and the thickness of the second encapsulant layer 7 ranges from 20 $\mu$m to 200 $\mu$m. In specific applications, the thickness of the first encapsulant layer 4 is not less than that of the second encapsulant layer 7, and the thickness of the first encapsulant layer 4 is preferably in the range of 250 $\mu$m to 300 $\mu$m. The first encapsulant layer 4 may be made of epoxy resin or silicone resin, and the second encapsulant layer 7 may also be made of either epoxy resin or silicone resin.

Further, as shown in FIG. 17 and FIG. 18, there is at least one pair of bonding pads in the corresponding area of each window structure, the LED chips 1 are disposed in the window structure and connected to the bonding pads in the corresponding window structure. The first encapsulant layer 4 is in direct contact with the substrate through the window structure. Specifically, the first encapsulant layer 4 includes an outer encapsulant layer located at the outer periphery of the LED chip 1 and a bottom encapsulant layer located at the window structure. The bottom encapsulant layer is formed by filling the window structure with the first encapsulant and is directly connected with the substrate 6, which is not only conducive to die bonding but also improves the lighting effect, backlight brightness, and process yield and lowers manufacturing cost.

An embodiment of the present disclosure also provides a manufacturing method of an LED lamp panel, which is used for manufacturing the above LED lamp panel, which includes the following steps:

a substrate 6 is prepared, which may be a FR4 circuit substrate or glass substrate;
a circuit layer 3 with bonding pads is disposed on the substrate 6. In specific applications, a solder resist layer 8 is also disposed above the circuit layer 3. The solder resist layer 8 is disposed in other areas of the circuit layer except the bonding pads, which has the function of insulation and oxidation prevention. The solder resist layer 8 is generally made of ink, white ink when applied to backlight products, and black ink when applied to direct view products;
the LEDs chip 1 are connected to the bonding pads. In specific applications, the solder paste layer 2 can be disposed on the bonding pad for facilitating welding;
as shown in FIG. 17, a first encapsulant layer 4 made of a first encapsulant is provided on one side of the substrate 6 to cover the LED chip 1 and the circuit layer 3. Specifically, the first encapsulant is disposed on one side of the substrate 6 by dispensing or molding and cured to form the first encapsulant layer 4; and
as shown in FIG. 18, a second encapsulant layer 7 made of a second encapsulant is provided on the other side of the substrate 6. Specifically, the second encapsulant is disposed on the other side of the substrate 6 by dispensing or molding to form the second encapsulant layer 7. The first encapsulant layer 4 and the second encapsulant layer 7 form a sandwich structure with the substrate 6, so that the tensile stress acting on both sides of the substrate 6 is offset to a great extent, effectively reducing the warping deformation in the substrate 6 (especially the substrate 6) caused by the stress exerted by the encapsulant layer, effectively improving the problems of delamination, deformation and poor air tightness of the lamp panel after encapsulation, and avoiding the bad risks such as peeling off of the LED chip 1

According to the LED lamp panel and the manufacturing method thereof provided by the embodiment of the present disclosure, the first encapsulant layer 4 is disposed on one side of the substrate 6 and covers the LED chip 1 and the circuit layer 3, the second encapsulant layer 7 is disposed on the other side of the substrate 6, and a sandwich structure is formed with the substrate 6 through the first encapsulant layer 4 and the second encapsulant layer 7, so that the stress acting on both sides of the substrate 6 can be offset to a great extent. The problems such as warping and deformation of the substrate 6 caused by stress are effectively reduced, delamination, deformation, and poor air tightness of the lamp panel after encapsulation are effectively improved, adverse risks such as peeling of the LED chip 1 are avoided, and the production cost is low.

Embodiment 4

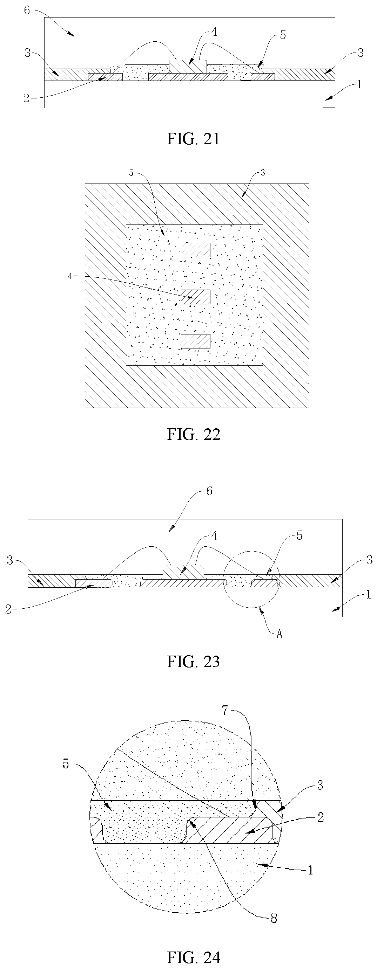

As shown in FIG. 20 to FIG. 23, an LED lamp panel provided by an embodiment of the present disclosure includes a substrate 1, a circuit composite layer (including a circuit layer 2 and a solder resist layer 3 with a window structure disposed on the circuit layer 2), a solder resist layer 3, a LED chip 4, and a colored glue layer 5. The circuit layer 2 is disposed on the substrate 1, and the solder resist layer 3 has at least one window structure. The solder resist layer 3 is disposed on the circuit layer 2. Specifically, the solder resist layer 3 is located at the top and the periphery of the circuit layer 2 and at least partially covers the peripheral edge of the circuit layer 2. The LED chip 4 is located in the window structure and connected to the circuit layer 2. In specific applications, there may be a plurality of LED chips 4, and the solder resist layer 3 may be correspondingly provided with a plurality of window structures, and each window structure is provided with one LED chip 4. The colored glue layer 5 is filled in the window structure, and the colored glue layer 5 is respectively connected with the LED chip 4 and the solder resist layer 3. Specifically, the colored glue layer 5 can be connected with the periphery of the LED chip 4, and the side surface of the colored glue layer 5 can be connected with the solder resist layer 3, as shown in FIG. 20. Alternatively, in another embodiment, the colored glue layer 5 can partially cover the top of the solder resist layer 3, as shown in FIG. 21. The color of the colored glue layer 5 is the same as that of the solder resist layer 3. Specifically, in one embodiment, when the LED lamp panel is used for white LED products, the colored glue layer 5 is a white glue layer, which can partially cover the circuit layer 2 around the LED chip 4 by disposing the white glue layer in the window structure. When the LED chip 4 emits light, by disposing the white glue layer around the LED chip 4, the reflectivity of the surrounding area of the LED chip 4 is improved, and the reflection effect is improved, so that the luminous brightness of the white LED product is improved, without the need of changing the size of the lamp bead and the size of the LED chip 4, and the brightness of the white LED can be effectively improved without improving the luminous efficiency of the chip, with a good improvement effect and a low cost. In another embodiment provided by the present disclosure, the LED lamp panel is used in an RGB-LED direct view product, the solder resist layer is black, and the colored glue layer 5 is a black glue layer. The blackness of the black glue layer can be adjusted to ensure that the blackness is sufficiently matched with the blackness of the solder resist layer, so that the light reflection around the RGB-LED chip 4 is reduced, and the contrast can be effectively improved. In other embodiments, the LED lamp panel is used for monochromatic LED products, and the colored glue layer 5 is a colored glue layer with a color system corresponding to the color of the solder resist layer. For example, if the LED lamp panel is a red LED product, the colored glue layer 5 is a red glue layer, so that it is not mixed with other variegated colors to ensure the light purity. Of course, the LED lamp panel can also be other monochromatic LED products such as blue and green, and the colored glue layer 5 is correspondingly set as a blue glue layer and a red glue layer. According to the LED lamp panel provided by the embodiment of the present disclosure, except that the top of the LED chip 4 is exposed from the substrate 1, the colored glue layer 5 with the same color as the solder resist layer 3 can completely cover the rest area of the substrate 1, that is, the colored glue layer 5 is disposed in the window structure and can also cover the surrounding area of the LED chip 4, so that the surface color consistency of the encapsulated substrate can be effectively improved. Different colored colloids can be applied to improve the luminous brightness or contrast according to different occasions. In specific applications, when used in white LED products, a white glue layer can be used to enhance the reflective effect of the area around the LED chip 4 and effectively improve the brightness of white light; when used in RGB-LED direct view products, a black glue layer can be used to reduce the reflection of the area around the RGB-LED chip, reduce the reflection effect, and effectively improve the contrast; when used in monochromatic LED products, a colored glue layer 5 corresponding to the color system is adopted, which can prevent the light emitted by the LED chip 4 from mixing with other miscellaneous colors and ensure the light purity.

Further, the upper end of the colored glue layer 5 and the upper end of the solder resist layer 3 are both lower than the upper end of the LED chip 4, the top of the LED chip 4 is exposed, and a large enough area for reflecting the light emitted by the LED chip 4 is formed around the LED chip 4. The colored glue layer 5 can be higher than the solder resist layer 3 and lower than the LED chip 4; that is, the top of the colored glue layer 5 can be located between the top surface of the solder resist layer 3 and the top surface of the LED chip 4.

Further, the thickness of the solder resist layer 3 ranges from 20 μm to 50 μm. In this embodiment, the thickness of the solder resist layer 3 is 30 μm. In specific applications, the solder resist layer 3 and the window structure can be molded at the same time (by an etching process). The solder resist layer 3 is formed by curing solder resist ink.

Further, the LED lamp panel further includes an encapsulant layer 6 that is disposed on the top of the solder resist layer 3 and the top of the colored glue layer 5 and covers the LED chip 4. Specifically, the encapsulant layer 6 covers the LED chip 4 and covers wires (gold wires) used for connection between the LED chip 4 and the circuit layer 2. The encapsulant layer 6 can be a transparent glue layer, and the transparent glue layer is formed by transparent glue encapsulation. According to the embodiment provided by the present disclosure, the display screen lamp beads can improve the brightness of products under the condition of sealing a transparent glue, or the visual effect of the lamp beads is completely black under the condition of sealing a transparent glue to greatly improve the contrast.

Furthermore, the colored glue layer 5 is made of the same material as the encapsulant layer 6, which can avoid the gap or repulsion of the contact part due to different materials, and the attachment at the joint is more fitted. Both the colored glue layer 5 and the encapsulant layer 6 can be made of epoxy resin, and in another embodiment, they may also be made of silica gel, which has a low cost and a good stability.

Further, the colored glue layer 5 is made of colored ink or colored colloid with a viscosity less than 2000 mPa·S. Specifically, the colored glue layer 5 is formed by solidification of colored colloid. The viscosity of colored colloid is the key, which affects its fluidity. The colored colloid is sprayed on the functional area around the LED chip 4 (that is, the window structure), and the viscosity range of the colored colloid is 0-2,000 mPa·S. Under the liquid surface tension and capillary action of the colored colloid, the colored colloid is evenly spread on the bottom surface of the lamp bead. By controlling the amount of colored colloid, after the colored colloid is cured, the bottom of the substrate 1 (PCB substrate in this embodiment) is covered with colored colloid except the LED chip 4, and the color of the functional area changes with the color of the colored colloid.

Further, as shown in FIG. 23 and FIG. 24, the inner sidewall of the window structure or the circuit layer has a fillet or chamfer structure. Specifically, in this embodiment, the lower and upper ends of the inner sidewall of the window structure have a fillet structure 7, and the fillet structure 7 may also be replaced by a chamfer structure, so that the colored glue layer 5 can be better combined with the inner sidewall of the window structure to avoid bubbles and cavities. Specifically, the inner sidewall of the circuit layer 3 may also have a fillet structure 8. The inner sidewall of the window structure can have any one of a curved surface, an inclined surface, or a rough surface, and the lower end and the upper end of the inner sidewall of the window structure extend in mutually opposite directions to ensure that there is no gap between the colored glue layer 5 formed by filling colored colloid and the inner sidewall of the window structure. There are a plurality of window structures, and one or more LED chips 4 are wire-bonded chips or flip chips and are fixed in each window structure. The LED lamp panel can be applied to traditional lamp beads and mini COB products.

An embodiment of the present disclosure also provides a manufacturing method for manufacturing the above LED lamp panel, which includes the following steps:

a substrate 1 is prepared, wherein the substrate 1 is a PCB substrate;

a circuit layer 2 is disposed on the substrate 1;

a solder resist layer 3 is disposed on the substrate 1, and the solder resist layer 3 has a window structure, which can be specifically formed by an etching process; the solder resist layer 3 is located at the outer periphery of the circuit layer 2 and at least partially covers the outer peripheral edge of the circuit layer 2; in specific applications, the solder resist layer 3 and the window structure can be formed simultaneously; more specifically, the thickness of the solder resist layer 3 ranges from 20 $\mu$m to 50 $\mu$m;

an LED chip 4 is disposed in the window structure and is connected with the circuit layer 2; in specific applications, the connection between the LED chip 4 and the circuit layer 2 can be realized by wires (gold wires);

colored colloid or colored ink with the same color as the solder resist layer 3 is filled into the window structure to form a colored glue layer 5, which is respectively connected with the LED chip 4 and the solder resist layer 3; in this embodiment, the colored glue layer 5 may be in contact with the outer periphery of the LED chip 4; in an embodiment, the side surface of the colored glue layer 5 is in contact with the solder resist layer 3, or in another embodiment, the colored glue layer 5 may partially cover the top of the solder resist layer 3.

According to the LED lamp panel and the manufacturing method thereof provided by the embodiment of the present disclosure, except that the LED chip 4 is exposed out of the substrate 1, the colored glue layer 5 with the same color as the solder resist layer 3 is respectively connected with the LED chip 4 and the solder resist layer 3, and the colored glue layer 5 can completely cover the rest area of the substrate 1; that is, the colored glue layer 5 may be filled in the window structure and may also cover the surrounding area of the LED chip 4, so that the surface color consistency of the encapsulated substrate can be effectively improved. Colloids with different colors can be applied to improve the luminous brightness or contrast according to different occasions. When the LED encapsulation structure is used for white LED products, the white glue layer can enhance the reflective effect of the area around the LED chip 4, thus effectively improving the white brightness. When the LED encapsulation structure is used in RGB-LED direct view products, the black glue layer can reduce the reflection of the area around the RGB-LED chip, reduce the reflection effect, and effectively improve the contrast. When the LED encapsulation structure is used for monochromatic LED products, the colored glue layer 5 with a color system corresponding to the color of the solder resist layer is adopted, which can prevent the light emitted by the LED chip 4 from mixing with other miscellaneous colors and ensure the light purity.

The above embodiments are only preferred embodiments of the present disclosure, and they are not intended to limit the present disclosure. Any modification, equivalent substitution or improvement made within the spirit and principle of the present disclosure shall fall within the protection scope of the present disclosure.

## Claims

1. An LED lamp panel, comprising a substrate and an LED chip, wherein a circuit composite layer is disposed on the substrate, and the circuit composite layer is provided with bonding pads for connecting with the LED chip.

2. The LED lamp panel according to claim 1, wherein a first reflective layer is disposed on the circuit composite layer, and the first reflective layer is provided with a plurality of windowing structures, each windowing structure having at least one pair of the bonding pads in a corresponding area; and the LED chip is disposed in the windowing structure and connected to the bonding pads in the corresponding windowing structure, and an accommodating area is formed between an outer periphery of the LED chip and an inner periphery of the windowing structure; and the LED lamp panel further comprises a second reflective layer filled in the accommodating area.

3. The LED lamp panel according to claim 1, wherein the circuit composite layer comprises a circuit layer and a solder resist layer that is disposed on the circuit layer and has windowing structures, each of the windowing structure having at least one pair of the bonding pads in the corresponding area; and the LED chip is disposed in the windowing structure and connected to the bonding pads in the corresponding windowing structure; and the LED lamp panel further comprises a first encapsulant layer that is disposed on one side of the substrate, covers the LED chip and the circuit composite layer and allows the light emitted by the LED chip to pass through; and the LED lamp panel further comprises a second encapsulant layer disposed on the other side of the substrate for partially or completely offsetting a stress generated by the first encapsulant layer on the substrate.

4. The LED lamp panel according to claim 1, wherein the circuit composite layer comprises a circuit layer and a solder resist layer that is disposed on the circuit layer and has windowing structures, each of the windowing structures having at least one pair of the bonding pads in the corresponding area; and the LED chip is disposed in the windowing structure and connected to the bonding pads in the corresponding windowing structure; and the LED chip is located in the windowing structure and connected to the circuit layer; and the LED lamp panel further comprises a colored glue layer, which is filled in the windowing structure and is respectively connected with the LED chip and the solder resist layer, with a color being the same as that of the solder resist layer.

5. The LED lamp panel according to claim 2, wherein the second reflective layer is made of resin, and reflective particles are dispersed in the second reflective layer.

6. The LED lamp panel according to claim 5, wherein the second reflective layer is formed by glue dispensing in the windowing structure.

7. The LED lamp panel according to claim 2, wherein the LED chip is a flip chip, and a gap exists between a side of the LED chip facing the substrate and the substrate; and the second reflective layer comprises a side reflective part connected with the outer periphery of the LED chip and a bottom reflective part filled in the gap.

8. The LED lamp panel according to claim 2, wherein a surface of the bonding pad is provided with a solder paste layer configured for connecting with the LED chip, and the second reflective layer covers the periphery of a joint between the LED chip and the solder paste layer.

9. The LED lamp panel according to claim 2, 5, 6, 7 or 8, wherein a top surface of the first reflective layer is between a bottom surface and a top surface of the LED chip, and a top surface of the second reflective layer is not higher than the top surface of the first reflective layer.

10. The LED lamp panel according to claim 2, wherein the second reflective layer has a reflectivity greater than that of the first reflective layer.

11. The LED lamp panel according to claim 2, wherein the first reflective layer is made of white ink.

12. The LED lamp panel according to claim 2, wherein a value of a thickness of the first reflective layer ranges from 20 $\mu$m to 80 $\mu$m.

13. The LED lamp panel according to claim 2, wherein the dimensions of the window structure satisfy the following relationship:

$$Bx < Px, \ By < Py;$$

where Bx represents the largest dimension of the window structure in the transverse direction, By represents the largest dimension of the window structure in the longitudinal direction, Px represents the transverse spacing between two adjacent LED chips, and Py represents the longitudinal spacing between two adjacent LED chips.

14. The LED lamp panel according to claim 3, wherein the window structure is a rectangular through hole, and a length dimension of the rectangular through hole is greater than or equal to $\geq$2mm.

15. The LED lamp panel according to claim 2, wherein a plurality of LED chips are provided, and the LED lamp panel further comprises a plurality of reflection patterns; and the second reflective layer covers the substrate and the LED chips, and the reflection patterns are disposed on the upper surface of the second reflective layer; and the reflection pattern comprises a plurality of reflection units disposed at intervals, and air gaps are formed between the reflection units; and the reflection unit comprises resin and reflection particles dispersed in the resin, and a density of the reflection particles in a central area of the reflection pattern is greater than that in a peripheral region of the reflection pattern; and the first reflective layer is disposed on a side of the circuit composite layer connected with the LED chip, and a side of the second reflective layer covers the first reflective layer and the LED chips.

16. The LED lamp panel according to claim 15, wherein in one of the reflection patterns, an area of the air gap accounts for 20% to 80% of an area of an outline of the reflection pattern; and/or the reflection pattern has a thickness of 10 $\mu$m to 60 $\mu$m.

17. The LED lamp panel according to claim 15, wherein the reflection units comprise a reflection ring located in the central area of the reflection pattern.

18. The LED lamp panel according to claim 17, wherein the reflection unit comprises a plurality of reflection rings disposed concentrically, and there is a gap between adjacent reflection rings.

19. The LED lamp panel according to claim 18, wherein the periphery of the reflection ring is provided with reflection points, and a distribution density of the reflection points decreases with a distance from the center of the reflection pattern.

20. The LED lamp panel according to claim 15, wherein the reflection units comprise a plurality of reflection points around the center of the reflection pattern, and areas of the reflection points decrease with the distance from the center of the reflection pattern.

21. The LED lamp panel according to claim 15, wherein a reflectivity of the reflection units in the central area of the reflection pattern is greater than that of the reflection units in a peripheral area of the reflection pattern.

22. The LED lamp panel according to claim 21, wherein he reflection unit in the central area of the reflection pattern contains titanium dioxide particles, and the reflection unit in the peripheral area of the reflection pattern contains silicon dioxide particles.

23. The LED lamp panel according to claim 15, wherein the reflection pattern is formed by screen printing, and a sidewall of the reflection unit is provided with a demoulding inclined plane.

24. The LED lamp panel according to claim 15, further comprising an optical film disposed above the second reflective layer, wherein diffusion patterns are printed on a surface of the optical film, and the diffusion patterns of the optical film and the reflection patterns are disposed in a staggered manner.

25. The LED lamp panel according to claim 3, wherein a thickness of the first encapsulant layer is greater than that of the second encapsulant layer, the first encapsulant layer has a first thermal expansion coefficient, and the second encapsulant layer has a second thermal expansion coefficient greater than the first thermal expansion coefficient.

26. The LED lamp panel according to claim 25, wherein the first encapsulant layer and the second encapsulant layer are made of a same material, which is epoxy resin or silicone resin.

27. The LED lamp panel according to claim 25, wherein the first encapsulant layer is provided with inorganic light-transmitting particles for adjusting the thermal expansion coefficient thereof.

28. The LED lamp panel according to claim 27, wherein the inorganic light-transmitting particles settle in the first encapsulant layer, so that the content of the inorganic light-transmitting particles gradually decreases along a direction away from the substrate.

29. The LED lamp panel according to claim 27, wherein a particle size of the inorganic light-transmitting particles ranges from 50nm to 5μm.

30. The LED lamp panel according to claim 27, wherein the inorganic light-transmitting particles are at least one of silica powder or alumina powder.

31. The LED lamp panel according to claim 3, wherein the thickness of the first encapsulant layer ranges from 150μm to 400μm; and/or the thickness of the second encapsulant layer ranges from 20 μm to 200μm.

32. The LED lamp panel according to claim 3, wherein the first encapsulant layer is in direct contact with the substrate through the windowing structure.

33. The LED lamp panel according to claim 4, wherein an upper end of the colored glue layer and an upper end of the solder resist layer are both lower than an upper end of the LED chip.

34. The LED lamp panel according to claim 4, wherein a thickness of the solder resist layer ranges from 20μm to 50μm.

35. The LED lamp panel according to claim 4, wherein the LED lamp panel further comprise encapsulant layers disposed on the top of the solder resist layer and the top of the colored glue layer and covering the LED chips.

36. The LED lamp panel according to claim 35, wherein the colored glue layer and the encapsulant layers are made of a same material, which is epoxy resin or silica gel.

37. The LED lamp panel according to claim 4, wherein the colors of the colored glue layer and the solder resist layer are white or black.

38. The LED lamp panel according to claim 4, wherein the colored glue layer is made of colored ink or colored colloid with a viscosity less than 2000 mPa·s.

39. The LED lamp panel according to claim 38, wherein an inner sidewall of the windowing structure or the circuit layer has a fillet or chamfer structure.

40. The LED lamp panel according to claim 4, wherein there are a plurality of windowing structures, and one or more LED chips are wire-bonded chips or flip chips and are fixed in respective windowing structures.

FIG. 1

FIG. 2

FIG. 3

FIG. 4

FIG. 5

FIG. 6

FIG. 7

FIG. 8

FIG. 9

FIG. 10

EP 4 546 040 A1

FIG. 11

FIG. 12

FIG. 13

FIG. 14

FIG. 15

FIG. 16

FIG. 17

FIG. 18

FIG. 19

FIG. 20

FIG. 21

FIG. 22

FIG. 23

FIG. 24

## INTERNATIONAL SEARCH REPORT

International application No.

**PCT/CN2023/102012**

### A. CLASSIFICATION OF SUBJECT MATTER

G02F1/13357(2006.01)i; H01L33/00(2010.01)i; H01L25/075(2006.01)i; H01L33/48(2010.01)i; H01L33/62(2010.01)i

According to International Patent Classification (IPC) or to both national classification and IPC

### B. FIELDS SEARCHED

Minimum documentation searched (classification system followed by classification symbols)

IPC:G02F1/-; H01L

Documentation searched other than minimum documentation to the extent that such documents are included in the fields searched

Electronic data base consulted during the international search (name of data base and, where practicable, search terms used)

CNTXT, ENTXTC, ENTXT, WPABS, DWPI, CNKI, IEEE: 发光二极管, 反射, 反光, 光板, 灯板, 基板, 电路板, 线路板, 翘曲, 变形, 树脂, 封装, 图案化, LED, reflect, lamp panel, light panel, base, PCB, warp, resin, package, pattern

### C. DOCUMENTS CONSIDERED TO BE RELEVANT

| Category* | Citation of document, with indication, where appropriate, of the relevant passages | Relevant to claim No. |
|---|---|---|
| PX | CN 115206950 A (SHENZHEN JUFEI OPTOELECTRONICS CO., LTD.) 18 October 2022 (2022-10-18) <br> claims 1-11 | 1-2, 5-14 |
| PX | CN 115084340 A (SHENZHEN JUFEI OPTOELECTRONICS CO., LTD.) 20 September 2022 (2022-09-20) <br> claims 1-9 | 1, 3, 25-32 |
| PX | CN 115347106 A (HUIZHOU JUFEI PHOTOELECTRIC CO., LTD.) 15 November 2022 (2022-11-15) <br> claims 1-9 | 1, 4, 33-40 |
| PX | CN 115986041 A (HUIZHOU JUFEI PHOTOELECTRIC CO., LTD.) 18 April 2023 (2023-04-18) <br> claims 1-10 | 1, 15-24 |
| X | CN 113126363 A (HISENSE VISUAL TECHNOLOGY CO., LTD.) 16 July 2021 (2021-07-16) <br> description, paragraphs [0044]-[0094], and figures 1-11 | 1-2, 4-14, 33-40 |

☑ Further documents are listed in the continuation of Box C.    ☑ See patent family annex.

| | |
|---|---|
| * Special categories of cited documents: <br> "A" document defining the general state of the art which is not considered to be of particular relevance <br> "D" document cited by the applicant in the international application <br> "E" earlier application or patent but published on or after the international filing date <br> "L" document which may throw doubts on priority claim(s) or which is cited to establish the publication date of another citation or other special reason (as specified) <br> "O" document referring to an oral disclosure, use, exhibition or other means <br> "P" document published prior to the international filing date but later than the priority date claimed | "T" later document published after the international filing date or priority date and not in conflict with the application but cited to understand the principle or theory underlying the invention <br> "X" document of particular relevance; the claimed invention cannot be considered novel or cannot be considered to involve an inventive step when the document is taken alone <br> "Y" document of particular relevance; the claimed invention cannot be considered to involve an inventive step when the document is combined with one or more other such documents, such combination being obvious to a person skilled in the art <br> "&" document member of the same patent family |

| Date of the actual completion of the international search | Date of mailing of the international search report |
|---|---|
| **18 July 2023** | **07 August 2023** |

| Name and mailing address of the ISA/CN | Authorized officer |
|---|---|
| China National Intellectual Property Administration (ISA/CN) <br> China No. 6, Xitucheng Road, Jimenqiao, Haidian District, Beijing 100088 | |
| | Telephone No. |

Form PCT/ISA/210 (second sheet) (July 2022)

**INTERNATIONAL SEARCH REPORT**

| International application No. |
| --- |
| **PCT/CN2023/102012** |

**C.    DOCUMENTS CONSIDERED TO BE RELEVANT**

| Category* | Citation of document, with indication, where appropriate, of the relevant passages | Relevant to claim No. |
| --- | --- | --- |
| Y | CN 113126363 A (HISENSE VISUAL TECHNOLOGY CO., LTD.) 16 July 2021 (2021-07-16)<br>    description, paragraphs [0044]-[0094], and figures 1-11 | 3, 25-32 |
| Y | CN 110517993 A (GUANGDONG FOZHIXIN MICROELECTRONICS TECHNOLOGY RESEARCH CO., LTD. et al.) 29 November 2019 (2019-11-29)<br>    description, paragraphs [0076]-[0102], and figure 16 | 3, 25-32 |
| A | CN 102052606 A (SHARP CORP.) 11 May 2011 (2011-05-11)<br>    entire document | 1-2 |
| A | CN 110018593 A (GUANGDONG OPPO MOBILE TELECOMMUNICATIONS CORP., LTD.) 16 July 2019 (2019-07-16)<br>    entire document | 7 |
| A | CN 113050326 A (WUHAN CHINA STAR OPTOELECTRONICS TECHNOLOGY CO., LTD.) 29 June 2021 (2021-06-29)<br>    entire document | 15-24 |

Form PCT/ISA/210 (second sheet) (July 2022)

INTERNATIONAL SEARCH REPORT
Information on patent family members

| Patent document cited in search report | | | Publication date (day/month/year) | Patent family member(s) | | | Publication date (day/month/year) |
|---|---|---|---|---|---|---|---|
| CN | 115206950 | A | 18 October 2022 | CN | 217881500 | U | 22 November 2022 |
| CN | 115084340 | A | 20 September 2022 | CN | 218351497 | U | 20 January 2023 |
| CN | 115347106 | A | 15 November 2022 | | None | | |
| CN | 115986041 | A | 18 April 2023 | | None | | |
| CN | 113126363 | A | 16 July 2021 | | None | | |
| CN | 110517993 | A | 29 November 2019 | | None | | |
| CN | 102052606 | A | 11 May 2011 | JP | 2011090977 | A | 06 May 2011 |
| | | | | US | 2011096265 | A1 | 28 April 2011 |
| CN | 110018593 | A | 16 July 2019 | CN | 110018593 | B | 17 May 2022 |
| CN | 113050326 | A | 29 June 2021 | | None | | |

Form PCT/ISA/210 (patent family annex) (July 2022)